# EUROPEAN PATENT APPLICATION

(11) **EP 1 970 345 A2**
(43) Date of publication of application: **17.09.2008**
(21) Application number: 08151793.0
(22) Date of filing: 22.02.2008
(51) Int. Cl.: B81C 1/00

(54) **Method and system for a composite polymer for printed MEMS**

(30) Priority: 16.03.2007 US 687317
(71) Applicant: Xerox Corporation, Rochester, New York 14644 (US)
(72) Inventor: Gulvin, Peter M., Webster, NY 14580 (US)
(74) Representative: Grünecker, Kinkeldey, Stockmair & Schwanhäusser Anwaltssozietät

(57) **Abstract**

An embodiment generally relates to a method for creating a composite material for micro-electro mechanical systems. The method includes determining a layout for a micro-electro mechanical system device and alternating depositing drops of polymer and drops of conductor to create an interwoven matrix based on the layout. The method also includes forming the micro-electro mechanical system device based on the layout.

## Description

### FIELD

This invention relates generally to printed micro-electro mechanical systems ("MEMS"), more particularly to a method and system for a composite polymer for printed MEMS.

### DESCRIPTION OF THE RELATED ART

Printed organic electronics is a relatively new field. Printed or plastic electronics is about the use of organic semiconductors (that is, conductive plastics, as opposed to traditional inorganic semiconductors such as silicon or gallium arsenide), their unique physical properties and a new approach they entail for electronic and optoelectronic device fabrication. The use of inks and standard printing technology to produce electronics and optoelectronics based on organic semiconductors has stimulated a massive commercial interest and a huge technical effort worldwide.

Applications of printed electronics include liquid crystal displays, organic light emitting diodes, radio frequency identification tags, ubiquitous signage, smart paper, photovoltaic cells and roll-up displays. The same technology can be used for printed MEMS, allowing for inexpensive, large-area sensors on a wide variety of substrates, potentially integrated with printed drive or signal processing electronics.

Some work done on printed MEMS technology has garnered greater interest in this technology. However, printed MEMS devices can face unique problems that printed electronics do not. For example, because MEMS are moving mechanical devices, they need conductors, insulators, structural layers and sacrificial layers, where the sacrificial layer is a stand-in for air gaps as with conventional MEMS. In most cases, the structural layers are conductive, filling two of these roles. In some standard polysilicon-based surface-micromachined MEMS processes, polysilicon is the structural material and conductor, silicon dioxide is the sacrificial material, and silicon nitride is the insulator. Metals are also used when higher conductivity is required. In printed MEMS, where the materials need to be jetted in liquid form from an inkjet printer, the structural material is likely to be a polymer, which typically isn't conductive. While conductive polymers are possible, these materials tend to have large resistivities. Moreover, restricting the choice of polymer to only those that are conductive makes it much more difficult to find the right combination of materials such that the sacrificial release etch does not attack the other materials.

### SUMMARY

An embodiment relates generally to a method for creating a composite material for micro-electro mechanical systems. The method includes determining a layout for a micro-electro mechanical system device and alternating depositing at least one drop of polymer and at least one drop of conductor to create an interwoven matrix based on the layout. The method also includes forming the micro-electro mechanical system device based on the layout.
In a further embodiment the conductor is one of silver, gold, aluminum, copper, and nickel.

Another embodiment pertains generally to a method of forming a conductive polymer for a micro-electro mechanical system device. The method includes determining a layout for the micro-electro mechanical system device and alternating depositing at least one layer of conductor with at least one layer of polymer to a pre-determined thickness of the conductive polymer. The method also includes forming vias through the conductive polymer according to the layout to form the micro-electro mechanical system device.
In a further embodiment the conductive polymer has at least one via in order to define a conductive area.
In a further embodiment the conductive polymer is free from vias in order to an insulative area.
In a further embodiment the method further comprises depositing a layer of a second conductor in response to the layout requiring a change in a conductive property.
In a further embodiment the method further comprises depositing a layer of a second polymer in response to the layout requiring a change in one of mechanical and chemical property.
In a further embodiment the conductor is one of silver, gold, aluminum, copper, and nickel.
In a further embodiment the polymer is one of polyimide, polyarylene ether (PAE), SU8, Benzocyclobutane-based polymers (BCBs), and liquid crystal polymers (LCPs).

Yet another embodiment relates generally to a system for forming a conductive polymer. The system includes a material printer configured to print out a micro-electro mechanical system according to a layout and a polymer material configured to be ejected from the material printer in drops. The system also includes a conductor material configured to be ejected from the material printer in drops. The material printer is configured to alternate depositing at least one drop of polymer and at least one drop of conductor to create an interwoven matrix based on the layout and forming the micro-electro mechanical system device based on the layout.
In a further embodiment the system further comprises a second polymer material configured to be ejected from the material printer, wherein the second polymer is selected in response to the layout requiring one of a second mechanical and chemical property.
In a further embodiment the system further comprises a second conductor material , wherein the second conductor is selected in response to the layout requiring another type of conductive property.
In a further embodiment the material printer is configured to stop the ejection of drops of conductor material in response to the layout requiring an insulating region.

### BRIEF DESCRIPTION OF THE DRAWINGS

Various features of the embodiments can be more fully appreciated, as the same become better understood with reference to the following detailed description of the embodiments when considered in connection with the accompanying figures, in which:
FIG. 1 illustrates an exemplary system in accordance with an embodiment;
FIG. 2 illustrates a composite film in accordance with another embodiment;
FIG. 3 illustrates a composite film in accordance with yet another embodiment; and
FIG. 4 illustrates another exemplary flow diagram in accordance with yet another embodiment.

### DETAILED DESCRIPTION OF EMBODIMENTS

For simplicity and illustrative purposes, the principles of the present invention are described by referring mainly to exemplary embodiments thereof However, one of ordinary skill in the art would readily recognize that the same principles are equally applicable to, and can be implemented in, all types of micro-electro mechanical systems ("MEMS") applications, and that any such variations do not depart from the true spirit and scope of the present invention. Moreover, in the following detailed description, references are made to the accompanying figures, which illustrate specific embodiments. Electrical, mechanical, logical and structural changes may be made to the embodiments without departing from the spirit and scope of the present invention. The following detailed description is, therefore, not to be taken in a limiting sense and the scope of the present invention is defined by the appended claims and their equivalents.

Embodiments relate generally to methods and systems for printed MEMS devices. More particularly, instead of developing new and exotic materials with the right mechanical, thermal and/or chemical properties for a particular MEMS application, a composite layer of polymer(s) and conductor(s) is created that combines standard materials in a number of ways to arrive at a material with the appropriate properties.

In one embodiment, an interwoven matrix can be created using a drop-by-drop deposition of polymer and conductor. As subsequent layers are deposited, the weave can be extended in three dimensions and create a structure with a large number of unbroken paths of conductor. The ratio of polymer-to-conductor and the relative positions of the drops could be varied to create composite films with different conductivities and/or mechanical properties. If the selected polymer is sufficiently insulating in certain areas with no added conductor drops, insulating regions can be created and route signals in whatever way is desired including in the vertical direction, allowing traces to overlap without shorting.

In a second embodiment, alternate layers of conductor and polymer are deposited until a target thickness is reached in the composite material. Subsequently, an array of vias is created between the layers to allow conductivity vertically through the composite material. In essence, an interwoven matrix similar to the first embodiment is created although not by a drop-by-drop process. Because of the differences in bonding, this arrangement can result in differences in the mechanical properties of the composite film as compared to the composite film created by the first embodiment. According to various embodiments, the layers and vias can be present through the entire thickness of the formed layered composite material or the layers and vias can be in selected spots, allowing for conductive and insulative areas in the composite material.

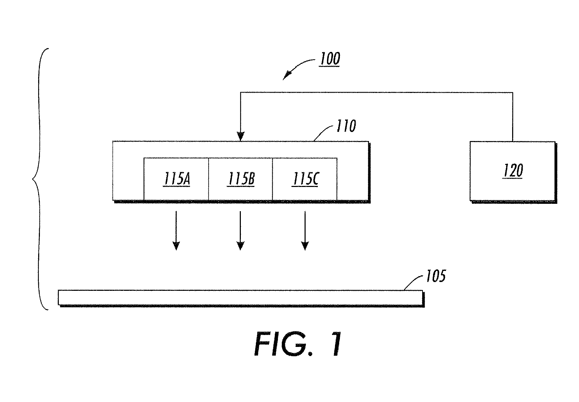

FIG. 1 illustrates an exemplary system 100 in accordance with an embodiment. It should be readily apparent to those of ordinary skill in the art that the system 100 depicted in FIG. 1 represents a generalized schematic illustration and that other components may be added or existing components may be removed or modified. Moreover, the system 100 may be implemented using software components, hardware components, or combinations thereof

As shown in FIG. 1, the system 100 includes a platen 105, a materials printer 110, and a controller 120. Although not shown, the system 100 can be configured to be in a clean room environment along with a temperature control system in some embodiments.

The platen 105 can be configured to provide a support surface for printed MEMS devices being formed thereon. The materials printer 110 can be a material inkjet printer such as Dimatix DMP-2800 Materials printer configured to jet materials from printheads 115A-C that form a selected device. Printheads 115A-C can be configured to have a cavity or cartridge configured to be filled with material or prefilled packet. Although materials printer 110 is shown with three printheads, it should be readily obvious that the number of printheads will be dependent on the selected model of the materials printer and the number of materials to be jetted.

The materials printer 110 can be configured to interface with the controller 120. The controller 120 can be configured to direct and manage the materials printer 110. More particularly, the controller 120 can execute the software that directs the materials printer to eject the correct material at the appropriate location and time according to a layout of a selected device. The controller 120 can also be configured with an interface (not shown) to receive layouts or plans of devices. The interface can be a disk drive, a universal serial bus interface, a network interface (e.g., Ethernet) or other similar information exchange interface known to those skilled in the art. In some embodiments, the controller 120 can be implemented as a workstation, a personal computer, a client, a control system or other similar computing platforms.

The system 100 can be configured to form printed MEMS devices through a composite film of standard materials. More particularly, instead of developing an exotic material, the specified electrical, mechanical, thermal, and chemical properties, embodiments of the present invention can be configured to create a composite layer of polymers(s) and conductor(s). These "standard" materials can be combined in various ways as further described below to arrive at the desired properties.

As a note, the polymer can be chosen to have the right structural properties (stiffness, plasticity, etc.) and to be chemically resistant to its environment and the release etch without consideration to conductivity. Examples of the polymer are polyimide, polyarylene ether (PAE), SU8, benzocyclobutane-based polymers (BCBs), and liquid crystal polymers (LCPs). Due to the fact that the polymers are selectively deposited and are thus not required to be photo-imageable, the list of suitable polymers can be much larger than in traditional polymer MEMS. The conductor can be almost anything, and if used in moderation can be made to contribute only slightly to the overall mechanical properties of the composite film. Examples of conductors are silver, gold, aluminum, copper, and nickel. The polymer can thus act as the structural layer, the conductive layers, or the insulating layer, depending on how it is combined with the conductor, a simplification from the conventional processes.

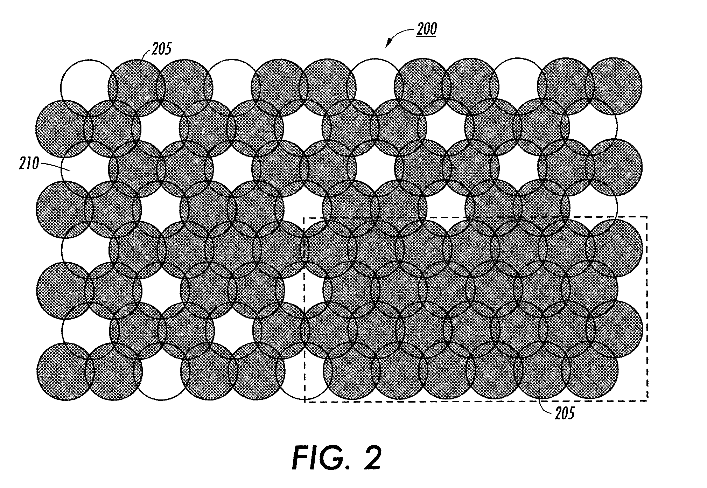

In some embodiments, the system 100 can be configured to create an interwoven matrix using a drop-by-drop deposition of polymer and conductor. As subsequent layers are deposited, the weave can be extended in three dimensions and create a structure with a large number of unbroken paths of conductor. The ratio of polymer-to-conductor and the relative positions of the drops could be varied to create composite films with different conductivities and/or mechanical properties. If the selected polymer is sufficiently insulating in certain areas with no added conductor drops, insulating regions can be created and route signals in whatever way is desired including in the vertical direction, allowing traces to overlap without shorting. An example of a layer of film created by this methodology is shown in FIG. 2.

FIG. 2 illustrates an example of a layer of composite film 200 in accordance with drop-by-drop methodology. As shown, polymer dots 205 are generally interspersed with conductor dots 210. Section 215 can be configured as a non-conductive area by a proliferation of polymer dots 205. Depending on the properties of the layer of film 200, subsequent layers of the film would be different than the layer shown. For example, conductive dots can be placed such that they complete the connections between conductive dots in the current layer of composite film 200.

In the shown embodiment, substantially one-third of the dots are conductive dots 210. However, the conductive dots 210 can be spread more sparsely to minimize the impact of the conductive dots 210 on the mechanical properties of the composite film.

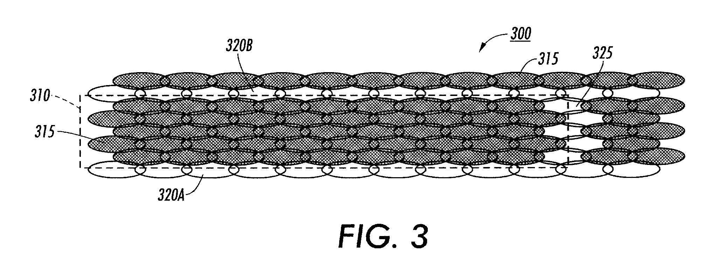

Alternatively, a second methodology can be used to create the composite film using standard materials. The system 100 can be used to create alternate layers of conductor and polymer deposited over a substrate until a target thickness is achieved. Subsequently, an array of vias is created between the layers to allow conductivity vertically through the composite material. In essence, an interwoven matrix similar to the first embodiment is created although not by a drop-by-drop process. Because of the differences in bonding, this arrangement can result in differences in the mechanical properties of the composite film as compared to the composite film created by the drop-by-drop methodology. An example of a composite film created by the layer-by-layer methodology is depicted in FIG. 3.

FIG. 3 illustrates a cross sectional view of a layer-wise interweaving in a composite film 300. As shown in FIG. 3, section 310 depicts several layers of polymer 315 sandwiched between conductor layers 320AB. A via 325 can be formed to connect the two layers, 320A and 320B together. In some embodiments, the layers and the vias can be present through the entire depth of the composite film 300 or they could be in selected spots allowing for conductive and insulative areas in the composite film 300.

Accordingly, depending on the behavior of the materials being used, one of the two approaches can provide an advantage over the other approach. In some embodiments, a combination of the two techniques can be used. For example, a combination would make sense if the conductor is susceptible to damage from the etchant used to remove the sacrificial layer. In that case, the outer layers should be polymer, encasing the conductor for protection, but the inner core could still be made of a drop-wise matrix of conductor and polymer. Another example is when the chemical selectivity between the polymer and the sacrificial material is low, risking damage to the structure during the release etch. If the conductor isn't affected by the release etch (which is likely, given that conductors and polymers are different chemically), then encasing the polymer or conductor/polymer matrix with a solid layer of conductor would make the process work.

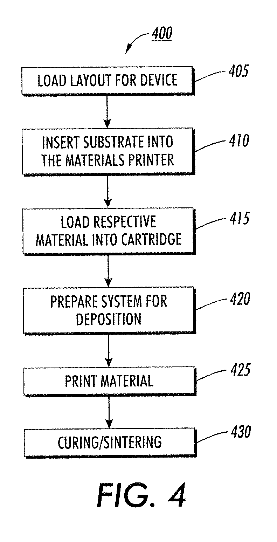

FIG. 4 illustrates a process flow diagram 400 implemented by the system 100 in accordance with yet another embodiment. It should be readily apparent to those of ordinary skill in the art that the process flow 300 depicted in FIG. 3 represents a generalized schematic illustration and that other steps may be added or existing steps may be removed or modified.

As shown in FIG. 4, the layout for a desired device can be loaded into the controller 120, in step 405. More particularly, a user can insert a disk or thumb drive into the appropriate interface of the controller 120 to transfer a created layout to the system 100. In some embodiments, the controller 120 can also be part of a system that executes software that provides users the capability to create layouts. Accordingly, users can save layouts in an internal location in the controller 120.

In step 410, a substrate can be inserted or placed on the platen 105 of the system 100. More particularly, if there are going to be multiple layers and/or multiple printheads being used, the printheads 115A-C can be aligned with alignment marks on the substrate.

In step 415, respective materials can be loaded in the printheads 115A-C. The choice of materials can be a function of the requirements of the desired device. In step 420, the system 100 can be prepared for deposition. More particularly, heat can be applied to the printheads 115A-C and/or substrate to achieve the proper conditions to achieve specified jetting/wetting characteristics, i.e., properly formed drops, target drop size, sufficient adhesion to substrate/prior layers, etc.

In step 425, the materials printer 110 can activate the appropriate printhead 115 to begin depositing materials mixed either by drop-by-drop or layer-by-layer methodology according to the loaded layout. More particularly, the materials printer 110 can begin printing the first material if the materials printer 110 has a single printhead. For a multiple-printhead materials printer, simultaneous ejection from a first and second printhead can be achieved unless the second material would run together with the first material. Then, this would require the first material deposited to dry before the application of the second material.

As a processing note, if single drop does not provide the required thickness, additional drops can be ejected either right after the first drops hits or after a time period to allow drying of the first drop.

In step 430, if required, a bake for the purpose of sintering the metal and/or curing the polymer can be applied on a layer-by-layer basis or on the finished device. If conducted on a layer-by-layer basis, steps 420-430 are repeated until the device is completed.

By using the embodiments of the present invention, printed MEMS could provide a mechanism to try out ideas quickly and inexpensively. More particularly, once devices are designed, the printing process will take minutes to hours, whereas a typical fabrication process requires one-to-three months. Typically MEMS process runs include $10K-$20K in photomask costs as well as $50K-$100K for fabrication. In contrast, printed MEMS requires no masks and the costs for fabrication are the substrate and the materials being deposited, which are used sparingly because they are only placed where needed. In addition, printed MEMS can enable full width array inkjet printheads, distributed large-area sensors and actuators, and new types of materials printers.

Certain embodiments may be performed as a computer program. The computer program may exist in a variety of forms both active and inactive. For example, the computer program can exist as software program(s) comprised of program instructions in source code, object code, executable code or other formats; firmware pragram(s); or hardware description language (HDL) files. Any of the above can be embodied on a computer readable medium, which include storage devices and signals, in compressed or uncompressed form. Exemplary computer readable storage devices include conventional computer system RAM (random access memory), ROM (read-only memory), EPROM (erasable, programmable ROM), EEPROM (electrically erasable, programmable ROM), and magnetic or optical disks or tapes. Exemplary computer readable signals, whether modulated using a carrier or not, are signals that a computer system hosting or running the present invention can be configured to access, including signals downloaded through the Internet or other networks. Concrete examples of the foregoing include distribution of executable software program(s) of the computer program on a CD-ROM or via Internet download. In a sense, the Internet itself, as an abstract entity, is a computer readable medium. The same is true of computer networks in general.

## Claims

1. A method for creating a composite material for micro-electro mechanical systems, the method comprising:
determining a layout for a micro-electro mechanical system device;
alternating depositing at least one drop of polymer and at least one drop of conductor to create an interwoven matrix based on the layout; and
forming the micro-electro mechanical system device based on the layout.

2. The method of claim 1, further comprising selecting a second polymer in response to the layout requiring a second mechanical property.

3. The method of claim 1, further comprising selecting a second conductor in response to the layout requiring another type of conductive property.

4. The method of claim 1, further comprising stopping the drops of conductor in response to the layout requiring an insulating region.

5. The method of claim 1, wherein the layout does not include a photomask.

6. The method of claim 1, wherein the alternating depositing drops of polymer and drops of conductor originate from a materials printer.

7. The method of claim 1, wherein the polymer is one of polyimide, polyarylene ether (PAE), SU8, Benzocyclobutane-based polymers (BCBs), and liquid crystal polymers (LCPs).

8. A method of forming a conductive polymer for a micro-electro mechanical system device, the method comprising
determining a layout for the micro-electro mechanical system device;
alternating depositing at least one layer of conductor with at least one layer of polymer to a pre-determined thickness of the conductive polymer; and
forming vias through the conductive polymer according to the layout to form the miro-electro mechanical system device.

9. A system for forming a conductive polymer, the system comprising:
a material printer configured to print out a micro-electro mechanical system according to a layout;
a polymer material configured to be ejected from the material printer in drops; and
a conductor material configured to be ejected from the material printer in drops, wherein the material printer is configured to alternate depositing at least one drop of polymer and at least one drop of conductor to create an interwoven matrix based on the layout and forming the micro-electro mechanical system device based on the layout.

10. A system for forming a conductive polymer, the system comprising:
a material printer configured to print out a micro-electro mechanical system according to a layout;
a polymer material configured to be ejected from the material printer in drops; and
a conductor material configured to be ejected from the material printer in drops, wherein the material printer is configured to alternately deposit layers of polymer and layers conductor based on the layout, and form vias according to the layout to form the micro-electro mechanical system device.
